# EUROPEAN PATENT APPLICATION

(11) **EP 2 624 445 A1**
(43) Date of publication of application: **07.08.2013**
(21) Application number: 12153624.7
(22) Date of filing: 02.02.2012
(51) Int. Cl.: H03B 21/01

(54) **Frequency generation**

(71) Applicant: Sequans Communications Limited, Reading, Berkshire RG41 5RB (GB)
(72) Inventor: Winiecki, Thomas, Reading, Berkshire RG41 5RB (GB); martin, Peter, Reading, Berkshire RG41 5RB (GB)
(74) Representative: Neobard, William John

(57) **Abstract**

A frequency generator has a first and a second two-input mixer, each having a respective output connected to a summing circuit. First inputs of the two mixers receive quadrature signals at a first frequency and second inputs receive quadrature signals at a second frequency. The frequency generator has frequency division circuitry having an input for a signal at the first frequency, with two outputs connected to respectively to the first and second mixers. The frequency division circuitry provides first and second signals at the second frequency, the first and second signals being in phase quadrature. Switching circuitry selectively routes the first signal to one of the first and second mixers and the second signal to the other of the first and second mixers

## Description

The disclosure relates to the general field of communication and to frequency generation.

In telecommunication systems a transmitting device emits signals as electromagnetic power in a well defined frequency band. The frequency band may be characterized in terms of its centre frequency and bandwidth. A receiver absorbs some of the transmitted power and converts it into a useable form. In many architectures, the transmitter first generates a representation of the signals at low frequency related to the signal bandwidth before modulating it onto a carrier wave which is a high fixed frequency corresponding to or close to the centre frequency of the output signal.

Similarly, the receiver strips the carrier wave from the received signal before processing the information further.

Both transmitter and receiver generate the carrier frequency in a functional block often referred to as the local oscillator or LO. The standard implementation is a phase-locked loop or PLL, containing a voltage-controlled oscillator or vco, whose frequency is maintained (or locked) at a multiple of a reference frequency which is typically a crystal oscillator. The multiple may be an integer number or, more commonly, a fractional number.

For devices communicating using 3^{rd} Generation Partnership Project's Long-Term Evolution standard, or 3GPP LTE standard, many different frequency bands are supported. 3GPP today defines more than thirty different bands with each band containing multiple channels. The multitude of bands reflects different spectrum allocations in different countries around the world.

For a transceiver design it is desirable to support as many bands as possible, if not all bands, so that a single transceiver may allow world-wide use. The challenge here lies in the wide range of carrier frequency used currently spanning from 698 MHz to 3800 MHz. In particular, generation of the local oscillator across such a wide band is a challenge as a the vco tuning range cannot be made large enough without compromising other performance characteristics such as phase noise and power consumption.

Various schemes exist to allow the local carrier frequency to be changed to select different channels or frequency bands.

Fine-tuning of the vco frequency is achieved through the voltage control as is part of the phase-locked loop mechanism. Coarse vco frequency tuning may be achieved by switching in and out capacitance. Increase in capacitance slows down the natural oscillation frequency of the vco while a reduction speeds it up. The capacitance may also be modified by using voltage dependent components called varactors, which change capacitance depending on applied voltage signal. Another possible method of coarse tuning is changing the vco inductor size by switching in or out tracks. These methods can achieve a relatively wide tuning range of the vco, maybe ±40% around a centre value, but as a side-effect, the vco current consumption typically increases and the phase noise performance suffers when the tuning range is pushed too high.

Another strategy used for generation of the LO frequency is the use of frequency dividers. In particular, divide-by-2 and divide-by-4 circuits are commonly used to generate lower frequencies than the original vco frequency and also to generate quadrature representation of the LO frequency (i.e. sine and cosine wave forms) which are ideal for quadrature transmitter and receiver architectures.

US 7184724 discloses an example of a known single side band mixer. Referring to Figure 1, a single side band mixer (1) consists of a first (13) and a second (23) two-input mixer, each having a respective output (14,24) connected to a summing circuit (33) at its two inputs (31,32), first inputs (11,21) of the two mixers arranged to receive quadrature signals at a first angular frequency ω₁ and second inputs (12,22) arranged to receive quadrature signals at a second angular frequency ω₂.

Where the summing circuit (33) is connected to add the signals at its inputs (31,32) its output (34) is |ω₁ + ω₂|, the so-called "upper sideband"; where the summing circuit (33) is connected to subtract the signals at its inputs (31,32) its output (34) is |ω₁ - ω₂| the so-called "lower sideband". There are various techniques for generating the 90° phase difference at the mixer inputs, for example through divide-by-2 circuits, polyphase filters or a combination of low-pass and high-pass filters.

In the illustrated case the two first inputs (11,21) receive signals derived from an input frequency source (3) via a phase shifter (5) that derives the quadrature first angular frequency signals. The two second input (12,22) receive signals from a second input frequency source (4) via a second phase shifter (6) that yields the quadrature second angular frequency signals

LO generation schemes based on single sideband mixers may have the advantage that the frequency generated at the output is not harmonically related to the vco frequency input. In other words, there is no integer ratio between input and output frequency. This eliminates the risk of vco pulling in transmitters where the high output power transmitted couples back to the vco leading to signal distortions.

An aim of examples is a device for generating the local oscillator for support of all 3GPP frequency bands using a single vco with narrow tuning range and a low complexity scheme of mixers and dividers. Another aim is an architecture that enables signals drawn to be implemented as differential signals thereby to minimize susceptibility to power supply noise, to reduce radiation of energy to other parts of the system and also to reduce pick-up of noise from other parts of the system.

In one aspect, there is disclosed a frequency generator by which an output frequency may be selected from a wide frequency range by mixing an input frequency signal with a frequency-divided version of that input frequency signal, wherein the factor by which division occurs is selectable.

In a second aspect there is provided an arrangement for providing a local oscillator frequency for a transceiver for covering the frequencies of the 3GPP LTE standard.

The frequencies may span from 698 MHz to 3800 MHz.

The arrangement may include two frequency dividers, the first operating on an input frequency variable between 7445 Mhz and 10240 Mhz to provide a first signal, and controllable to provide a divisor of 2, 4 or 8, thereby to provide a second signal, a switch for selecting between a lower and upper sideband frequency third signal when the first and second signals are mixed, and the second operating on the third signal and having a divisor controllable to be 2 or 4.

The arrangement may receive controls to provide the following effects

| Input frequency MHz | First divider | Second divider | U/L sideband | Local oscillator (MHZ) |
|---|---|---|---|---|
| | 2 | 2 | Upper | 2792-3840 |
| | 8 | 2 | Upper | 2094-2880 |
| 7440......10240 | 4 | 2 | Lower | 1396-1920 |
| | 8 | 2 | Lower | 1629-2240 |
| | 4 | 4 | Lower | 698-960 |

In another aspect, there is disclosed a frequency generator comprising a first and a second two-input mixer, each having a respective output connected to a summing circuit, first inputs of the two mixers arranged to receive quadrature signals at a first frequency and second inputs arranged to receive quadrature signals at a second frequency, the frequency generator further comprising frequency division circuitry having an input for a signal at the first frequency and having two outputs connected to respectively to the first and second mixers, the frequency division circuitry being operable to provide first and second signals at the second frequency, the first and second signals being in phase quadrature, and switching circuitry for selectively routing the first signal to one of the first and second mixers and the second signal to the other of the first and second mixers.

In one example a frequency division ratio of the frequency division circuitry is selectable to control the output frequency of the frequency generator.

In one example the switching circuitry has a control input for controlling the routing of the first and second signals to select the output frequency of the frequency generator

The summing circuit may have an output connected to the input of further frequency division circuitry having an output from which the output frequency of the frequency generator is derived.

A frequency division ratio of the further frequency division circuitry may be selectable to control the output frequency of the frequency generator.

The input of the frequency division circuitry may be provided at the output of an addition circuit, whose inputs are the quadrature signals at the first frequency.

The frequency generator may have a retroactively controlled frequency source for providing the quadrature signals at a first frequency.

The frequency source may comprises a voltage controlled oscillator providing an output of double the first frequency, and a divide-by-two receiving the output of the voltage controlled oscillator and providing therefore the first frequency

An input to the retroactively controlled frequency source may be derived from the output of the addition circuit.

There is also disclosed a method of generating an output of a selectable frequency comprising:- providing two quadrature signals of first frequency; deriving two quadrature signals of second frequency by dividing the first frequency by a selectable factor; mixing one signal of first frequency with one signal of second frequency to provide one signal; and the other signal of first frequency with the other signal of second frequency to provide a second signal; and selectively summing or differencing the first and second signals to provide a third signal.

The method may further comprise dividing the frequency of the third signal by a selectable factor to provide a desired output.

In the drawings,

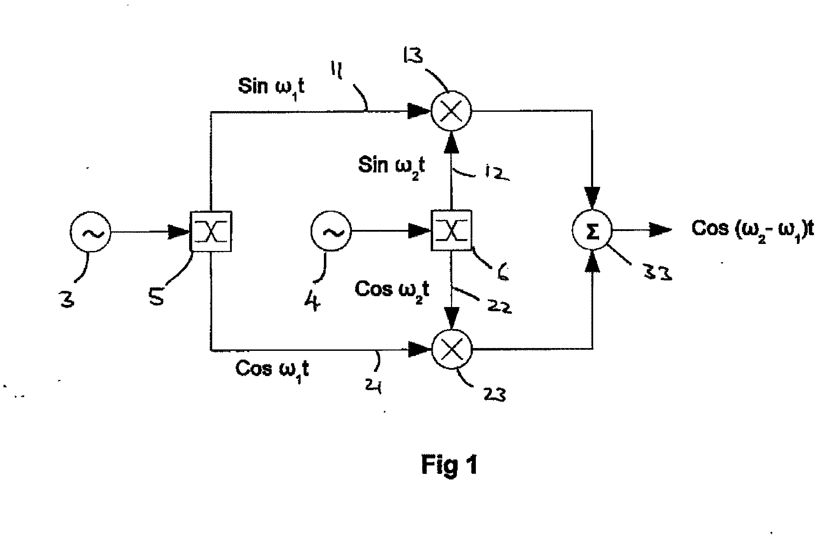

Figure 1 shows a block schematic diagram of a single sideband mixer; and
Figure 2 shows an example of a frequency generator

In the figures, like reference signs refer to like parts

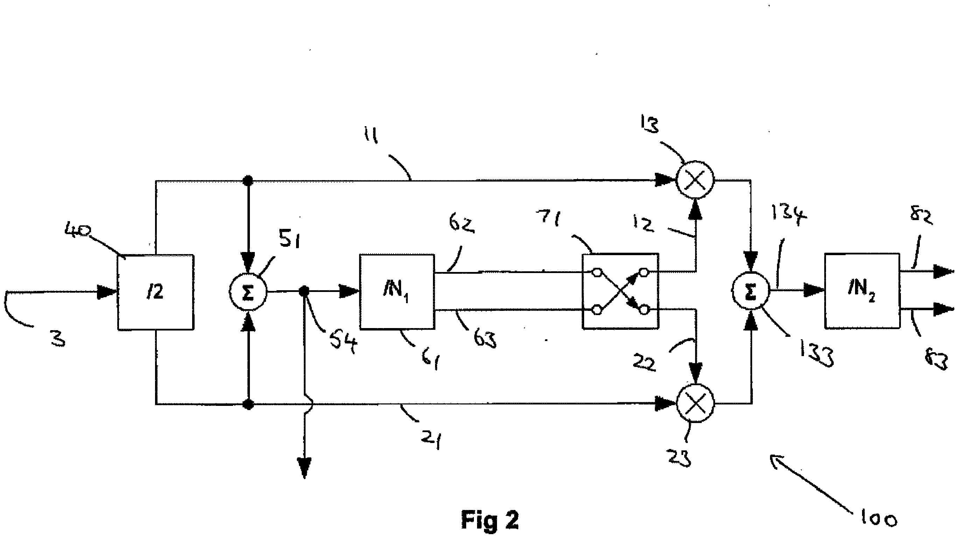

Referring to Fig 2, a frequency generator (100) for a communications transceiver has a first (13) and a second (23) two-input mixer, each having a respective output connected to a summing circuit (133). First inputs (11,21) of the two mixers (13,23) are arranged to receive quadrature signals at a first frequency ω/2 from a divide-by-two (40). Second inputs (12,22) are arranged to receive quadrature signals at a second frequency ω/2N₁ derived from a divide-by-N₁ circuitry (61).

The divide-by-N₁ circuitry (61) has an input node (54) for a signal at the first frequency ω/2. The input node (54) is connected to the output of an addition circuit (51). The addition circuit (51) is provided to preserve the symmetry of the circuit and load each divide-by-2 output (11,21) equally. In another embodiment the input node (54) is connected directly to one of the outputs (11,21) of the divide-by-two circuit (40).

The divide-by-N₁ circuitry (61) has two quadrature outputs (62,63), connected to the first and second mixers (13,23) via changeover switching circuitry (71) which connects either the first output (62) to the first mixer (13) and the second output (63) to the second mixer (23) or vice-versa.

The summing circuit (133) has an output (134) connected to divide-by-N₂ circuitry (81) having two quadrature outputs (82, 83)

The divide-by-two (40) receives its input frequency ω (3) from a voltage controlled oscillator of a retroactive stabilised frequency circuit (not shown). This may be a frequency locked loop or a phase locked loop. The divide-by-two (40) therefore provides as its output the first frequency ω/2.

In this example the input node (54) of the divide-by-N₁ circuitry (61) provides the feedback signal to the loop ,thus closing the loop. In other examples, the loop is closed from another node in the circuit -any may be used- but this is a convenient choice as the frequency is lower than the vco frequency but not dependent on any divider setting.

The divide-by-N₁ circuitry (61) is set to divide by a factor of 2, 4, or 8 depending on the selected frequency band. The table below shows the choice of N₁ for each 3GPP band.

The divide-by-N₁ circuitry is followed by the switch (71) which can be set up to swap the outputs from the divide-by- N₁ or to pass them directly.

This allows the single sideband mixer to provide either the upper or lower sideband at the addition circuit output (134). The selected side band is divided by N₂ in the divide-by-N₂ circuitry, and the quadrature outputs (82,83) are the LO frequency of interest (N2 = 2, 4).

The table lists example settings for N₁ and N₂ as well as the setting of switch (71)-"swap" means that the output (62) is input to second mixer (23) and that output (63) is input for first mixer (13)- necessary for covering all 3GPP bands.

| f_{LO}(MHz) | Configuration [N_{1,} N₂, Swap] | f_{LO}/f/_{CO} | f_{LO}(MHz) | Suitable for 3GPP bands |
|---|---|---|---|---|
| | [2, 2, no] | 3/8 | 2792 ... 3840 | 42, 43 |
| | [8, 2, no] | 9/32 | 2094... 2880 | 7, 38, 40, 41 |
| 7445... 10240 | [4, 2, yes] | 3/16 | 1396 ... 1920 | 11 ,21, 24 |
| | [8, 2, yes] | 7/32 | 1629 ... 2240 | 1-4, 9, 10, 23, 25, 33-37, 39 |
| | [4,4, yes] | 3/32 | 698... 960 | 5, 6, 8,12-14, 17-20, 26 |

All 3GPP bands can be covered with just five configuration settings reducing the amount of testing and verification needed to a minimum.

The required vco frequency range is 8842.5MHz±15.8% which can easily be achieved with well known tuning techniques (e.g. switchable bank of capacitors.)

Combinations of N₁ and N₂ that lead to output frequencies harmonically related to the vco frequency are not used in the scheme.

A further small reduction of the vco tuning range is possible if the PLL is used exclusively for either receive or transmit frequencies because the 3GPP frequency bands are slightly offset for uplink and downlink direction (for frequency division multiplexing, or FDD, bands 1-26).

Note that it is also possible to run the scheme from half the vco frequency (and half the ratio of N2 provided in the table) with any of the following modifications: (1) the initial divide-by-two is replaced by another means of generating quadrature tones. (2) 3.5GHz bands (E-UTRAN band 42 and 43) are not supported and all values for N₂ are halved and (3) final division stage is replaced by another means for 3.5 GHz bands e.g. N₂=1 + polyphase filter, or (4) LO quadrature signals are not required by the transceiver architecture

The example allows generation of carrier frequencies of all 3GPP E-UTRAN frequency bands using a single vco with narrow tuning range (±16%) and a compact arrangement of dividers and mixers. The scheme generates frequencies that are not harmonically related to the vco frequency which eliminated the risk of vco pulling. All circuits use differential signals and are symmetrically balanced to maximize rejection of power supply noise and minimize radiation or pick-up of high frequency signals to other blocks in the RF system. The output LO signals can be represented in terms of in-phase and quadrature-phase (cosine and sine) signals which makes it ideally suited for quadrature modulation and de-modulation schemes.

The invention is not restricted to the specific arrangement illustrated.

## Claims

1. A frequency generator comprising a first and a second two-input mixer, each having a respective output connected to a summing circuit, first inputs of the two mixers arranged to receive quadrature signals at a first frequency and second inputs arranged to receive quadrature signals at a second frequency, the frequency generator further comprising frequency division circuitry having an input for a signal at the first frequency and having two outputs connected to respectively to the first and second mixers, the frequency division circuitry being operable to provide first and second signals at the second frequency, the first and second signals being in phase quadrature, and switching circuitry for selectively routing the first signal to one of the first and second mixers and the second signal to the other of the first and second mixers.

2. The frequency generator of claim 1, wherein a frequency division ratio of the frequency division circuitry is selectable to control the output frequency of the frequency generator.

3. The frequency generator of claim 1 or 2 wherein the switching circuitry has a control input for controlling the routing of the first and second signals to select the output frequency of the frequency generator

4. The frequency generator of claim 1, 2 or 3 wherein the summing circuit has an output, and the output is connected to the input of further frequency division circuitry having an output from which the output frequency of the frequency generator is derived.

5. The frequency generator of claim 4, wherein a frequency division ratio of the further frequency division circuitry is selectable to control the output frequency of the frequency generator.

6. The frequency generator of any preceding claim, wherein the input of the frequency division circuitry is provided at the output of an addition circuit, whose inputs are the quadrature signals at the first frequency.

7. The frequency generator of any preceding claim comprising a retroactively controlled frequency source for providing the quadrature signals at a first frequency.

8. The frequency generator of claim 6, wherein retroactive feedback to the retroactively controlled frequency source is derived from the output of the addition circuit..

9. A method of generating an output of a selectable frequency comprising:- providing two quadrature signals of first frequency;
deriving two quadrature signals of second frequency by dividing the first frequency by a selectable factor;
mixing one signal of first frequency with one signal of second frequency to provide one signal; and the other signal of first frequency with the other signal of second frequency to provide a second signal; and
selectively summing or differencing the first and second signals to provide a third signal.

10. The method of claim 9, further comprising dividing the frequency of the third signal by a selectable factor to provide a desired output.
